# EUROPEAN PATENT SPECIFICATION

(11) **EP 4 686 354 B1**
(45) Date of publication and mention of the grant of the patent: **09.12.2026**
(21) Application number: 25170462.3
(22) Date of filing: 14.04.2025
(51) Int. Cl.: H10K 30/40, H10K 30/57, H10K 30/83, H10F 77/00, H10K 85/50

(54) **PEROVSKITE TANDEM SOLAR CELL**
PEROWSKIT-TANDEMSOLARZELLE
CELLULE SOLAIRE TANDEM À BASE DE PÉROVSKITE

(30) Priority: 25.07.2024 CN 202411009487
(43) Date of publication of application: 28.01.2026
(73) Proprietor: Zhejiang Jinko Solar Co., Ltd., Haining, Zhejiang 314416 (CN)
(72) Inventor: WANG, Jungan, HAINING, 314416 (CN); XU, Menglei, HAINING, 314416 (CN); YANG, Jie, ZHEJIANG, 314416 (CN); ZHANG, Xinyu, HAINING, 314416 (CN)
(74) Representative: Haseltine Lake Kempner LLP

(56) References cited:
- CN-A- 113 809 237
- CN-A- 115 206 957
- US-A1- 20230 110 770
- SOFIA SARAH E ET AL: "Metal Grid Contact Design for Four-Terminal Tandem Solar Cells", IEEE JOURNAL OF PHOTOVOLTAICS, IEEE, vol. 7, no. 3, 1 May 2017 (2017-05-01), pages 934 - 940, XP011646678, ISSN: 2156-3381, [retrieved on 20170420], DOI: 10.1109/JPHOTOV.2017.2686651
- KIM SANGHO ET AL: "Over 30% efficiency bifacial 4-terminal perovskite-heterojunction silicon tandem solar cells with spectral albedo", vol. 11, no. 1, 30 July 2021 (2021-07-30), US, XP093314470, ISSN: 2045-2322, Retrieved from the Internet <URL:https://www.nature.com/articles/s41598-021-94848-4> DOI: 10.1038/s41598-021-94848-4

## Description

### TECHNICAL FIELD

The present application relates to the technical field of new energy conversion and new energy cell modules, and particularly to a perovskite tandem solar cell.

### BACKGROUND

Due to their excellent photoelectric performance, such as high optical absorption coefficient, long carrier diffusion length, and high defect tolerance, the light energy conversion efficiency of organic-inorganic hybrid perovskite solar cells continues to rise. It has increased from 3.8% to 26.1% in a short period of more than ten years. In addition, since the band gap of perovskite is adjustable, the efficiency of four-terminal perovskite/silicon tandem cells formed by perovskite as the top cell and silicon as the bottom cell has exceeded 33% due to their matching absorption of the solar light spectrum.

However, the poor charge transport capability of the transparent top electrode of perovskite affects the light conversion efficiency of four-terminal tandem cells.

SOFIA SARAH E ET AL: Metal Grid Contact Design for Four-Terminal Tandem Solar Cells", IEEE JOURNAL OF PHOTOVOLTAICS, IEEE, vol. 7, no. 3, 1 May 2017 (2017-05-01), pages 934-940.

KIM SANGHO ET AL: "Over 30% efficiency bifacial 4-terminal perovskite heterojunction silicon tandem solar cells with spectral albedo", SCIENTIFIC REPORTS, vol. 11, no. 1, 30 July 2021 (2021-07-30).

CN 113 809 237 A describes a perovskite/crystalline silicon tandem solar cell device.

US 2023/110770 A1 describes methods of making semiconductor perovskite layers and compositions thereof.

.CN 115 206 957 A describes a tandem solar cell and its preparation method.

### SUMMARY

Accordingly, it is necessary to provide a perovskite tandem solar cell to solve the problems of poor charge transport capability and low light conversion efficiency of four-terminal tandem cells.

A perovskite tandem solar cell is provided, including:
a crystalline silicon cell; and
a plurality of perovskite cell provided above the crystalline silicon cell, and each perovskite cell includes a first transparent electrode, a buffer layer, a first carrier transport layer, a perovskite layer, a second carrier transport layer, and a conductive glass that are sequentially stacked from top to bottom.

Each perovskite cell further includes a plurality of metal grid lines spaced apart on the first transparent electrode, and the metal grid lines extend on the first transparent electrode along a horizontal direction.

The crystalline silicon cell includes a plurality of metal busbars spaced apart on a top and/or a bottom of the crystalline silicon cell, the metal busbars extend along the horizontal direction.

The metal grid lines and the metal busbars extend along the same direction.

A number of the plurality of metal grid lines is the same as a number of the plurality of metal busbars, and the plurality of metal grid lines are arranged above the plurality of metal busbars in a one-to-one correspondence, wherein a plurality of perovskite cells are spaced apart above the crystalline silicon cell, and a first groove is provided between adjacent perovskite cells, wherein a projection of the metal grid lines on a first plane is in a Z-shape, the first plane is a plane parallel to an extending direction of the metal grid lines, each metal grid line comprises a first horizontal portion, a vertical portion, and a second horizontal portion, the first horizontal portion is provided on the first transparent electrode and is connected to a top of the vertical portion, the vertical portion covers a side wall of the first groove, the second horizontal portion is provided on a bottom wall of the first groove and is connected to a bottom of the vertical portion, and the second horizontal portion is spaced apart from adjacent perovskite cells.

Optionally, along a direction perpendicular to an extending direction of the metal grid lines, two side boundaries of a projection of the metal grid lines on the crystalline silicon cell fall within two side boundaries of a projection of the metal busbars on the crystalline silicon cell.

Optionally, each perovskite cell includes:
a plurality of first metal grid lines extending on the first transparent electrode along a first horizontal direction, and the plurality of first metal grid lines are spaced apart along a second horizontal direction; and
a plurality of second metal grid lines extending on the first transparent electrode along the second horizontal direction, and the plurality of second metal grid lines are spaced apart along the first horizontal direction.

The plurality of first metal grid lines and the plurality of second metal grid lines intersect to form a grid pattern.

Optionally, the crystalline silicon cell includes:
a plurality of metal busbars spaced apart on the top and/or the bottom of the crystalline silicon cell, and the plurality of metal busbars extend along the first horizontal direction, and are spaced apart along the second horizontal direction; and
a plurality of fingers spaced apart on the top and/or the bottom of the crystalline silicon cell, the plurality of fingers extend along the second horizontal direction and are spaced apart along the first horizontal direction. The plurality of metal busbars and the plurality of fingers intersect to form a grid pattern on the top and/or the bottom of the crystalline silicon cell.

Optionally, each first metal grid line is arranged above one corresponding metal busbar, and each second metal grid line is arranged above one corresponding finger.

Optionally, the first metal grid lines perpendicularly intersect with the second metal grid lines, and at least one second metal grid line perpendicularly intersecting with the first metal grid line of the perovskite cell is provided on the same perovskite cell.

Optionally, a width of the metal grid lines is 0.5 mm to 5 mm.

A material of the metal grid lines includes at least one of gold, silver, copper, and aluminum.

The first carrier transport layer is an Electron Transport Layer (ETL) or a Hole Transport Layer (HTL), and the second carrier transport layer is also an Electron Transport Layer (ETL) or a Hole Transport Layer (HTL).

In the perovskite tandem solar cell provided in the aforementioned embodiments, the transparent electrode of the perovskite layer is bonded with the metal by means of the metal grid lines provided on the surface of the perovskite layer, which improves the conductivity of the perovskite layer, reduces the contact resistance of the transparent electrode, and improves the fill factor of the perovskite layer. Furthermore, the metal grid lines of the perovskite layer can be precisely aligned with the metal grid lines of the cell layer, which avoids the impact of increasing the metal grid lines on the illumination area received by the perovskite tandem solar cell, thereby improving the light conversion efficiency of the perovskite tandem solar cell.

### BRIEF DESCRIPTION OF THE DRAWINGS

Various additional advantages and benefits will become apparent to those of ordinary skill in the art by reading the following detailed description of the embodiments. The accompanying drawings are only for the purpose of illustrating the embodiments and are not to be considered limiting of the present application. In addition, the same reference numerals are used to represent the same components throughout the accompanying drawings. In the accompanying drawings:
FIG. 1 is a cross-sectional view of a perovskite tandem solar cell provided according to the claimed invention;
FIG. 2 is a perspective view of a perovskite tandem solar cell provided according to the claimed invention;
FIG. 3 is a cross-sectional view of a perovskite tandem solar cell provided according to another embodiment of the present application, but not forming part of the claimed invention;
FIG. 4 is a perspective view of a perovskite tandem solar cell provided according to another embodiment of the present application, but not forming part of the claimed invention;
FIG. 5 is a cross-sectional view of a perovskite tandem solar cell provided according to still another embodiment of the present application;
FIG. 6 is a perspective view of a perovskite tandem solar cell provided according to still another embodiment of the present application;
FIG. 7 is a cross-sectional view of a perovskite tandem solar cell provided according to yet another embodiment of the present application, but not forming part of the claimed invention;
FIG. 8 is a perspective view of a perovskite tandem solar cell provided according to yet another embodiment of the present application, but not forming part of the claimed invention;
FIG. 9 is a schematic view of a cutting process route for a perovskite cell provided according to an embodiment of the present application.

### DETAILED DESCRIPTION

In order to make the above objectives, features and advantages of the present application more obvious and understandable, specific embodiments of the present application are described in detail below with reference to the accompanying drawings. Numerous specific details are set forth in the following description in order to provide a thorough understanding of the present application. However, the present application can be implemented in many other ways than those described herein, and those skilled in the art can make similar improvements without departing from the present application. Therefore, the present application is not limited to the specific embodiments disclosed below.

All technical and scientific terms used herein have the same meaning as commonly understood by those of ordinary skill in the art to which the present application applies, unless otherwise defined. In the description of the present application, it should be understood that the terms "first" and "second" are used for descriptive purposes only, and cannot be constructed as indicating or implying a relative importance, or implicitly specifying the number of the indicated technical features. Therefore, the features defined with "first" and "second" may explicitly or implicitly include at least one of the features. In the description of the present application, "plurality" means at least two, such as two, three, etc., unless otherwise specifically defined.

The terms used in the specification of the present application herein are for the purpose of describing specific embodiments only and are not intended to limit the present application. It should be understood that when an element is referred to as being "connected to" another element, the element may be directly connected to another element, or there may be an intermediate element therebetween. Instead, when an element is referred to as being "directly" connected to another element, there is no intermediate element.

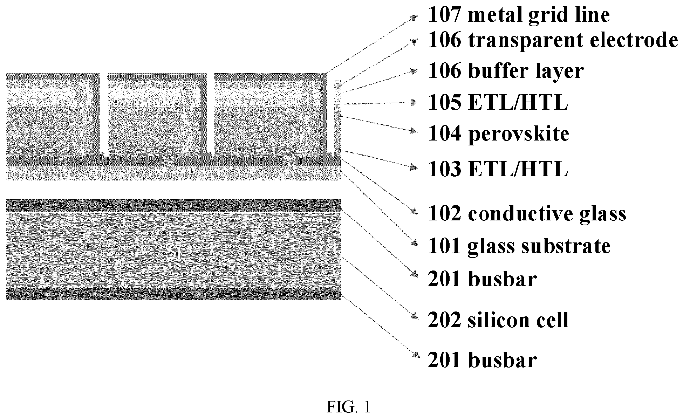

Referring to FIGS. 1 to 2, which correspond to the claimed invention, the present application provides a perovskite tandem solar cell 100. The perovskite tandem solar cell 100 includes a crystalline silicon cell and at least one perovskite cell provided above the crystalline silicon cell.

Each perovskite cell includes a first transparent electrode, a buffer layer, a first carrier transport layer, a perovskite layer, a second carrier transport layer, and a conductive glass that are sequentially stacked from top to bottom. In this embodiment, the first carrier transport layer can be an Electron Transport Layer (ETL) or a Hole Transport Layer (HTL). The second carrier transport layer has the same structural material as the first carrier transport layer, that is, the second carrier transport layer may also be an Electron Transport Layer (ETL) or a Hole Transport Layer (HTL). The first transparent electrode is not only arranged on the buffer layer, but also vertically interspersed among the buffer layer, the first carrier transport layer, the perovskite layer, and the second carrier transport layer. A glass substrate is provided below the conductive glass. The glass substrate is used to carry the conductive glass and ensure that the spacing between each conductive glass is the same.

Each perovskite cell further includes a plurality of metal grid lines that are spaced apart on the first transparent electrode, and the metal grid lines extend on the first transparent electrode along a horizontal direction. In this embodiment, the plurality of metal grid lines are arranged in parallel, and the spacing between adjacent metal grid lines is the same. A material of the metal grid lines can be one or more alloys of elements such as gold, silver, copper, and aluminum.

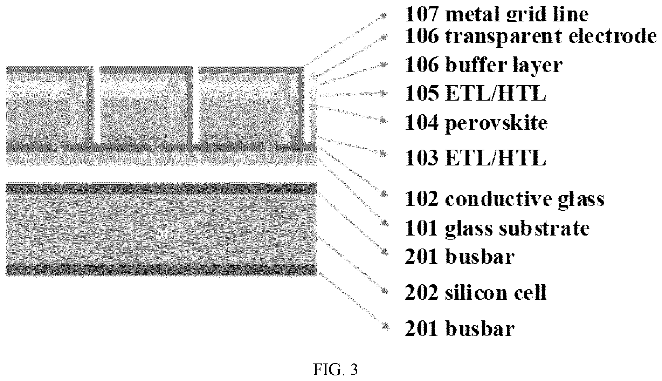

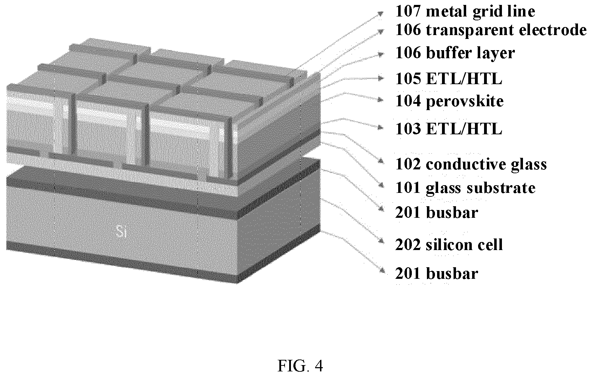

The crystalline silicon cell includes a plurality of metal busbars that are spaced apart on a top and/or a bottom of the crystalline silicon cell, and the metal busbars extend along the horizontal direction. In this embodiment, the metal busbars on the top and the metal busbars on the bottom are distributed in the same manner and are parallel straight lines belonging to the same plane in the vertical direction. As shown in FIGS. 3 and 4, the metal busbars can also be a whole metal grid plate having the same size as the upper surface/lower surface of the crystalline silicon cell. When the metal busbars are grid lines, the metal grid lines on the perovskite cell, the metal busbars on the top of the crystalline silicon cell, and the metal busbars on the bottom of the crystalline silicon cell are parallel to each other on the same vertical section. In this way, when sunlight radiates on the top of perovskite cell, the contact area between the crystalline silicon cell and sunlight is preserved to the maximum extent, thereby improving absorption and conversion efficiency of solar energy by the perovskite cell.

The metal grid lines and the metal busbars extend along the same direction. A number of the plurality of metal grid lines is the same as a number of the plurality of metal busbars, and the plurality of metal grid lines are arranged above the plurality of metal busbars in a one-to-one correspondence. The transparent electrode of the perovskite layer is bonded with the metal by means of the metal grid lines provided on the surface of the perovskite layer, which improves the conductivity of the perovskite layer, reduces the contact resistance of the transparent electrode, and improves the fill factor of the perovskite layer. Furthermore, the metal grid lines of the perovskite layer can be precisely aligned with the metal grid lines of the cell layer, which avoids the impact of increasing the metal grid lines on the illumination area received by the perovskite tandem solar cell, thereby improving the light conversion efficiency of the four-terminal tandem cell.

Optionally, along a direction perpendicular to an extending direction of the metal grid lines, two side boundaries of a projection of the metal grid lines on the crystalline silicon cell fall within two side boundaries of a projection of the metal busbars on the crystalline silicon cell. In this way, the shielding range of the metal grid lines and the metal busbars to the illumination area received by the perovskite tandem solar cell can be reduced, thereby ensuring that the light conversion efficiency of the perovskite tandem solar cell is improved while improving the conductivity of the perovskite layer.

Optionally, each perovskite cell includes a plurality of first metal grid lines and a plurality of second metal grid lines. The plurality of first metal grid lines extend on the first transparent electrode along a first horizontal direction, and the plurality of first metal grid lines are spaced apart along a second horizontal direction. The plurality of second metal grid lines extend on the first transparent electrode along the second horizontal direction, and the plurality of second metal grid lines are spaced apart along the first horizontal direction. The plurality of first metal grid lines and the plurality of second metal grid lines intersect to form a grid pattern.

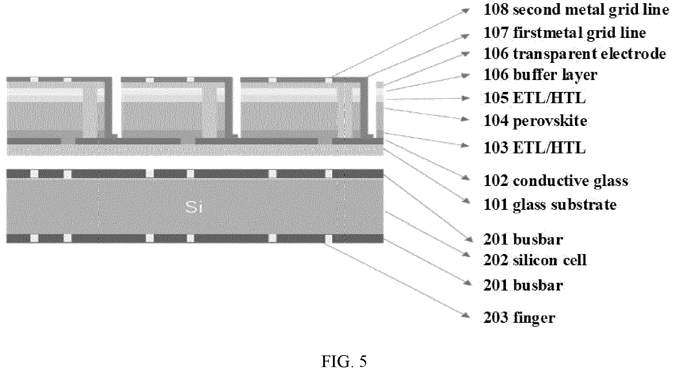

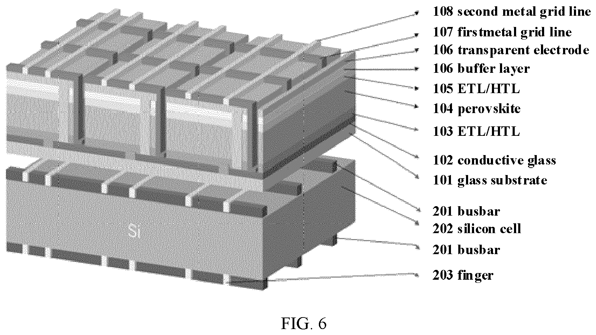

In this embodiment, as shown in FIGS. 5 and 6, the first metal grid lines perpendicularly intersect with the second metal grid lines. At least one second metal grid line perpendicularly intersecting with the first metal grid line of the perovskite cell is provided on the same perovskite cell. The second metal grid lines on the perovskite cell are parallel to each other. When more than one second metal grid line is provided on the perovskite cell, the spacing between the second metal grid lines on each perovskite cell may be different.

Optionally, the crystalline silicon cell includes a plurality of metal busbars and a plurality of fingers. The plurality of metal busbars are spaced apart on the top and/or the bottom of the crystalline silicon cell, and the plurality of metal busbars extend along the first horizontal direction, and are spaced apart along the second horizontal direction. The plurality of fingers are spaced apart on the top and/or the bottom of the crystalline silicon cell, and the plurality of fingers extend along the second horizontal direction and are spaced apart along the first horizontal direction. The plurality of metal busbars and the plurality of fingers intersect to form a grid pattern on the top and/or the bottom of the crystalline silicon cell.

In this embodiment, as shown in FIGS. 5 and 6, when a second metal grid line is provided on the perovskite cell, a plurality of fingers are provided on the top and the bottom of the crystalline silicon cell below the perovskite cell, respectively, and the plurality of fingers are provided in parallel. In the same vertical plane, one second metal grid line on the top layer of the perovskite cell, one finger on the crystalline silicon cell, and one finger under the crystalline silicon cell are at least included. And one second metal grid line on the top layer of the perovskite cell, one finger on the crystalline silicon cell, and one finger under the crystalline silicon cell are arranged parallel to each other.

Optionally, each first metal grid line is arranged above one corresponding metal busbar, and each second metal grid line is arranged above one corresponding finger.

Optionally, a width of the metal grid lines is 0.5 mm to 5 mm. A material of the metal grid lines includes at least one of gold, silver, copper, and aluminum.

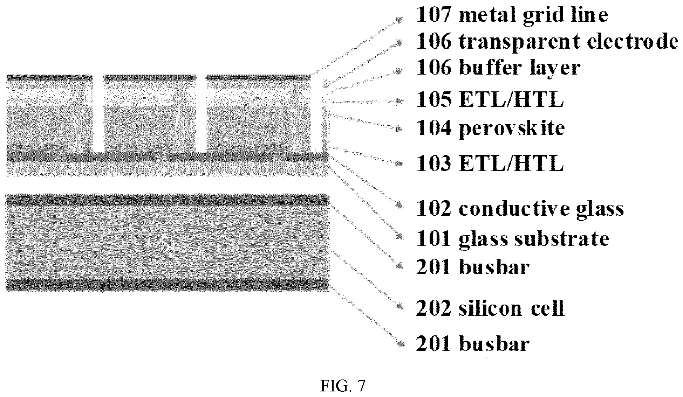

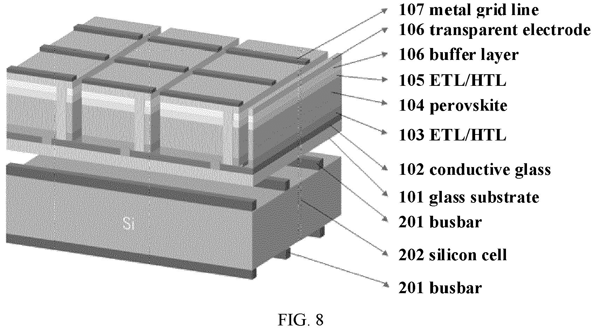

In an embodiment not forming part of the claimed invention, a projection of the metal grid lines on a first plane is in a straight-line shape, and the first plane is a plane parallel to an extending direction of the metal grid lines. In this embodiment, as shown in FIGS. 7 and 8, the metal grid lines are straight grid lines provided only on the surface of the transparent electrode. The straight grid lines are bonded with the transparent electrodes of each perovskite cell, respectively, thus reducing the contact resistance of the electrode and improving the conductivity of each perovskite cell.

In the claimed invention, a plurality of perovskite cells are spaced apart above the crystalline silicon cell, and a first groove is provided between adjacent perovskite cells. In an embodiment not forming part of the claimed invention, a projection of the metal grid lines on a first plane is in an inverted L-shape. The metal grid line includes a horizontal portion provided on the first transparent electrode and a vertical portion connected to the horizontal portion, the vertical portion is provided in the first groove and is spaced apart from adjacent perovskite cells. As shown in FIGS. 3 and 4, which do not correspond to the claimed invention, the metal grid lines are L-shaped grid lines provided on the upper surface of the transparent electrode and on the left side surface of each perovskite cell. The L-shaped grid lines can increase the contact length between the metal grid lines and the transparent electrode, which further reduces the contact resistance of electrode, thereby better improving the conductivity of the perovskite cell.

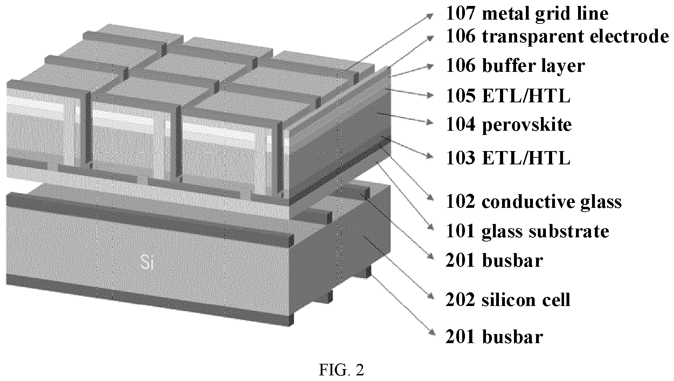

In the claimed invention, a projection of the metal grid lines on the first plane is in a Z-shape, and each metal grid line includes a first horizontal portion, a vertical portion, and a second horizontal portion. The first horizontal portion is provided on the first transparent electrode and is connected to a top of the vertical portion. The vertical portion covers a side wall of the first groove. The second horizontal portion is provided on a bottom wall of the first groove and is connected to a bottom of the vertical portion, and the second horizontal portion is spaced apart from adjacent perovskite cells. As shown in FIGS. 1 and 2, the metal grid lines are a Z-shaped grid lines that are provided on the upper surface of the transparent electrode, on the left surface of each perovskite cell, and between two perovskite cells. The Z-shaped grid lines can ensure that the two perovskite cells are not directly connected by the metal grid lines, such that the two perovskite cells are independent of each other. Meanwhile, it greatly improves the contact length between the metal grid lines and the transparent electrode, which further reduces the contact resistance of electrode, thereby better improving the conductivity of the perovskite cell.

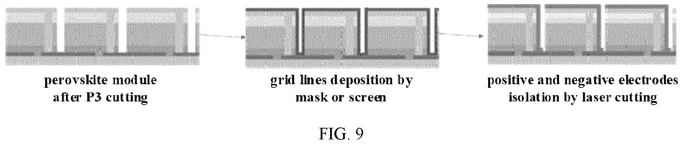

Optionally, on the perovskite cell, an initial metal grid line is prepared on the first transparent electrode by a mask deposition method or a screen deposition method, and the initial metal grid line is cut at each first groove by a laser process to obtain the metal grid lines of each perovskite cell. Specifically, as shown in FIG. 9, each perovskite cell is sub-perovskite cell prepared by the following. A whole perovskite cell is subjected to a P3 cutting process, after which metal grid lines are prepared by a mask deposition method or a screen deposition method, and then a laser process is used to perform a P3.5 cutting process, thereby cutting the grid lines to obtain a sub-perovskite cell with isolation of the positive and negative electrodes. The sub-perovskite cells are connected in series. The P3 cutting process is a cutting process that removes the top charge transport layer of a whole perovskite cell by a third cutting method, and cuts the whole perovskite cell into equal parts, by means of which a whole perovskite cell forms three n-layer perovskite cells of the same size. The P3.5 process is a cutting process that laser cuts the metal grid lines connecting each perovskite cell.

Each of the technical features of the aforementioned embodiments can be combined arbitrarily. To simplify the description, not all the possible combinations of the technical features in the aforementioned embodiments are described. However, all of the combinations of these technical features should be considered as within the scope of the present application, as long as such combinations do not contradict with each other.

## Claims

1. A perovskite tandem solar cell (100), comprising:
a crystalline silicon cell (202); and
at least one perovskite cell provided above the crystalline silicon cell (202), and each perovskite cell comprises a first transparent electrode (106), a buffer layer, a first carrier transport layer (105), a perovskite layer (104), a second carrier transport layer (103), and a conductive glass (102) that are sequentially stacked from top to bottom;
wherein each perovskite cell further comprises a plurality of metal grid lines (107) spaced apart on the first transparent electrode (106), and each metal grid line (107) extends on the first transparent electrode (106) along a horizontal direction;
wherein the crystalline silicon cell (202) comprises a plurality of metal busbars (201) spaced apart on a top and/or a bottom of the crystalline silicon cell (202), the metal busbars (201) extend along the horizontal direction; and the metal grid lines (107) and the metal busbars (201) extend along the same direction;
wherein a number of the plurality of metal grid lines (107) is the same as a number of the plurality of metal busbars (201), and the plurality of metal grid lines (107) are arranged above the plurality of metal busbars (201) in a one-to-one correspondence;
wherein a plurality of perovskite cells are spaced apart above the crystalline silicon cell (202), and a first groove is provided between adjacent perovskite cells;
wherein a projection of the metal grid lines (107) on a first plane is in a Z-shape, the first plane is a plane parallel to an extending direction of the metal grid lines (107), each metal grid line (107) comprises a first horizontal portion, a vertical portion, and a second horizontal portion, the first horizontal portion is provided on the first transparent electrode (106) and is connected to a top of the vertical portion, the vertical portion covers a side wall of the first groove, the second horizontal portion is provided on a bottom wall of the first groove and is connected to a bottom of the vertical portion, and the second horizontal portion is spaced apart from adjacent perovskite cells.

2. The perovskite tandem solar cell (100) according to claim 1, wherein along a direction perpendicular to an extending direction of the metal grid lines (107), two side boundaries of a projection of the metal grid lines (107) on the crystalline silicon cell (202) fall within two side boundaries of a projection of the metal busbars (201) on the crystalline silicon cell (202).

3. The perovskite tandem solar cell (100) according to claim 1, wherein each perovskite cell comprises:
a plurality of first metal grid lines (107) extending on the first transparent electrode (106) along a first horizontal direction, and the plurality of first metal grid lines (107) are spaced apart along a second horizontal direction; and
a plurality of second metal grid lines (108) extending on the first transparent electrode (106) along the second horizontal direction, and the plurality of second metal grid lines (108) are spaced apart along the first horizontal direction; wherein the plurality of first metal grid lines (107) and the plurality of second metal grid lines (108) intersect to form a grid pattern.

4. The perovskite tandem solar cell (100) according to claim 3, wherein the crystalline silicon cell (202) comprises:
a plurality of metal busbars (201) spaced apart on the top and/or the bottom of the crystalline silicon cell (202), and the plurality of metal busbars (201) extend along the first horizontal direction, and are spaced apart along the second horizontal direction; and
a plurality of fingers (203) spaced apart on the top and/or the bottom of the crystalline silicon cell (202), the plurality of fingers (203) extend along the second horizontal direction and are spaced apart along the first horizontal direction, and the plurality of metal busbars (201) and the plurality of fingers (203) intersect to form a grid pattern on the top and/or the bottom of the crystalline silicon cell.

5. The perovskite tandem solar cell (100) according to claim 4, wherein each first metal grid line (107) is arranged above one corresponding metal busbar (201), and each second metal grid line (108) is arranged above one corresponding finger (203).

6. The perovskite tandem solar cell (100) according to claim 4, wherein the first metal grid lines (107) perpendicularly intersect with the second metal grid lines (108), and at least one second metal grid line (108) perpendicularly intersecting with the first metal grid line (107) of the perovskite cell is provided on the same perovskite cell.

7. The perovskite tandem solar cell (100) according to any one of claims 1 to 4, wherein a width of the metal grid lines (107, 108) is 0.5 mm to 5 mm.

8. The perovskite tandem solar cell (100) according to any one of claims 1 to 4, wherein a material of the metal grid lines (107) comprises at least one of gold, silver, copper, and aluminum.

9. The perovskite tandem solar cell (100) according to claim 1, wherein the first carrier transport layer is an Electron Transport Layer (ETL) or a Hole Transport Layer (HTL), and the second carrier transport layer is also an Electron Transport Layer (ETL) or a Hole Transport Layer(HTL).

## Patentansprüche

1. Perowskit-Tandemsolarzelle (100), umfassend:
eine kristalline Siliziumzelle (202); und
mindestens eine Perowskitzelle, die oberhalb der kristallinen Siliziumzelle (202) bereitgestellt ist, und wobei jede Perowskitzelle eine erste transparente Elektrode (106), eine Pufferschicht, eine erste Trägertransportschicht (105), eine Perowskitschicht (104), eine zweite Trägertransportschicht (103) und ein elektrisch leitfähiges Glas (102) umfasst, die nacheinander von oben nach unten gestapelt sind;
wobei jede Perowskitzelle ferner eine Vielzahl von Metallgitterlinien (107) umfasst, die auf der ersten transparenten Elektrode (106) beabstandet sind, und sich jede Metallgitterlinie (107) auf der ersten transparenten Elektrode (106) entlang einer horizontalen Richtung erstreckt;
wobei die kristalline Siliziumzelle (202) eine Vielzahl von Metallsammelschienen (201) umfasst, die auf einer Oberseite und/oder einer Unterseite der kristallinen Siliziumzelle (202) beabstandet sind, wobei sich die Metallsammelschienen (201) entlang der horizontalen Richtung erstrecken; und sich die Metallgitterlinien (107) und die Metallsammelschienen (201) entlang der gleichen Richtung erstrecken;
wobei eine Anzahl der Vielzahl von Metallgitterlinien (107) gleich einer Anzahl der Vielzahl von Metallsammelschienen (201) ist und die Vielzahl von Metallgitterlinien (107) oberhalb der Vielzahl von Metallsammelschienen (201) in einer Eins-zu-eins-Entsprechung angeordnet ist;
wobei eine Vielzahl von Perowskitzellen oberhalb der kristallinen Siliziumzelle (202) beabstandet ist und eine erste Nut zwischen benachbarten Perowskitzellen bereitgestellt ist;
wobei eine Projektion der Metallgitterlinien (107) auf eine erste Ebene Z-förmig ist, die erste Ebene eine Ebene parallel zu einer Erstreckungsrichtung der Metallgitterlinien (107) ist, jede Metallgitterlinie (107) einen ersten horizontalen Abschnitt, einen vertikalen Abschnitt und einen zweiten horizontalen Abschnitt umfasst, der erste horizontale Abschnitt auf der ersten transparenten Elektrode (106) bereitgestellt ist und mit einer Oberseite des vertikalen Abschnitts verbunden ist, der vertikale Abschnitt eine Seitenwand der ersten Nut bedeckt, der zweite horizontale Abschnitt auf einer unterseitigen Wand der ersten Nut bereitgestellt ist und mit einer Unterseite des vertikalen Abschnitts verbunden ist und der zweite horizontale Abschnitt von benachbarten Perowskitzellen beabstandet ist.

2. Perowskit-Tandemsolarzelle (100) nach Anspruch 1, wobei entlang einer Richtung senkrecht zu einer Erstreckungsrichtung der Metallgitterlinien (107) zwei Seitenbegrenzungen einer Projektion der Metallgitterlinien (107) auf die kristalline Siliziumzelle (202) innerhalb zweier Seitenbegrenzungen einer Projektion der Metallsammelschienen (201) auf die kristalline Siliziumzelle (202) fallen.

3. Perowskit-Tandemsolarzelle (100) nach Anspruch 1, wobei jede Perowskitzelle Folgendes umfasst:
eine Vielzahl von ersten Metallgitterlinien (107), die sich auf der ersten transparenten Elektrode (106) entlang einer ersten horizontalen Richtung erstrecken, und wobei die Vielzahl von ersten Metallgitterlinien (107) entlang einer zweiten horizontalen Richtung beabstandet ist; und
eine Vielzahl von zweiten Metallgitterlinien (108), die sich auf der ersten transparenten Elektrode (106) entlang der zweiten horizontalen Richtung erstrecken, und wobei die Vielzahl von zweiten Metallgitterlinien (108) entlang der ersten horizontalen Richtung beabstandet ist; wobei sich die Vielzahl von ersten Metallgitterlinien (107) und die Vielzahl von zweiten Metallgitterlinien (108) schneiden, um ein Gittermuster auszubilden.

4. Perowskit-Tandemsolarzelle (100) nach Anspruch 3, wobei die kristalline Siliziumzelle (202) Folgendes umfasst:
eine Vielzahl von Metallsammelschienen (201), die auf der Oberseite und/oder der Unterseite der kristallinen Siliziumzelle (202) beabstandet sind, und wobei sich die Vielzahl von Metallsammelschienen (201) entlang der ersten horizontalen Richtung erstreckt und entlang der zweiten horizontalen Richtung beabstandet ist; und
eine Vielzahl von Fingern (203), die auf der Oberseite und/oder der Unterseite der kristallinen Siliziumzelle (202) beabstandet sind, wobei sich die Vielzahl von Fingern (203) entlang der zweiten horizontalen Richtung erstreckt und entlang der ersten horizontalen Richtung beabstandet ist und sich die Vielzahl von Metallsammelschienen (201) und die Vielzahl von Fingern (203) schneiden, um ein Gittermuster auf der Oberseite und/oder der Unterseite der kristallinen Siliziumzelle auszubilden.

5. Perowskit-Tandemsolarzelle (100) nach Anspruch 4, wobei jede erste Metallgitterlinie (107) oberhalb einer entsprechenden Metallsammelschiene (201) angeordnet ist und jede zweite Metallgitterlinie (108) oberhalb eines entsprechenden Fingers (203) angeordnet ist.

6. Perowskit-Tandemsolarzelle (100) nach Anspruch 4, wobei die ersten Metallgitterlinien (107) die zweiten Metallgitterlinien (108) senkrecht schneiden und mindestens eine zweite Metallgitterlinie (108), die die erste Metallgitterlinie (107) der Perowskitzelle senkrecht schneidet, auf der gleichen Perowskitzelle bereitgestellt ist.

7. Perowskit-Tandemsolarzelle (100) nach einem der Ansprüche 1 bis 4, wobei eine Breite der Metallgitterlinien (107, 108) 0,5 mm bis 5 mm ist.

8. Perowskit-Tandemsolarzelle (100) nach einem der Ansprüche 1 bis 4, wobei ein Material der Metallgitterlinien (107) mindestens eines von Gold, Silber, Kupfer und Aluminium umfasst.

9. Perowskit-Tandemsolarzelle (100) nach Anspruch 1, wobei die erste Trägertransportschicht eine Elektronentransportschicht (ETL) oder eine Lochtransportschicht (HTL) ist und die zweite Trägertransportschicht ebenfalls eine Elektronentransportschicht (ETL) oder eine Lochtransportschicht (HTL) ist.

## Revendications

1. Cellule solaire tandem à base de pérovskite (100), comprenant :
une cellule en silicium cristallin (202) ; et
au moins une cellule à base de pérovskite prévue au-dessus de la cellule en silicium cristallin (202), et chaque cellule à base de pérovskite comprend une première électrode transparente (106), une couche tampon, une première couche de transport de porteurs (105), une couche de pérovskite (104), une seconde couche de transport de porteurs (103) et un verre conducteur (102) qui sont empilés séquentiellement de haut en bas ;
dans laquelle chaque cellule à base de pérovskite comprend en outre une pluralité de lignes de grille métallique (107) espacées sur la première électrode transparente (106), et chaque ligne de grille métallique (107) s'étend sur la première électrode transparente (106) dans une direction horizontale ;
dans laquelle la cellule en silicium cristallin (202) comprend une pluralité de barres omnibus métalliques (201) espacées sur le dessus et/ou le dessous de la cellule en silicium cristallin (202), les barres omnibus métalliques (201) s'étendent dans la direction horizontale ; et les lignes de grille métallique (107) et les barres omnibus métalliques (201) s'étendent dans la même direction ;
dans laquelle un certain nombre de la pluralité de lignes de grille métallique (107) est le même qu'un certain nombre de la pluralité de barres omnibus métalliques (201), et la pluralité de lignes de grille métallique (107) est disposée au-dessus de la pluralité de barres omnibus métalliques (201) dans une correspondance biunivoque ;
dans laquelle une pluralité de cellules à base de pérovskite sont espacées au-dessus de la cellule en silicium cristallin (202), et une première rainure est prévue entre les cellules à base de pérovskite adjacentes ;
dans laquelle une projection des lignes de grille métallique (107) sur un premier plan est en forme de Z, le premier plan est un plan parallèle à une direction d'extension des lignes de grille métallique (107), chaque ligne de grille métallique (107) comprend une première partie horizontale, une partie verticale et une seconde partie horizontale, la première partie horizontale est prévue sur la première électrode transparente (106) et est reliée à un sommet de la partie verticale, la partie verticale recouvre une paroi latérale de la première rainure, la seconde partie horizontale est prévue sur une paroi inférieure de la première rainure et est reliée au bas de la partie verticale, et la seconde partie horizontale est espacée des cellules à base de pérovskite adjacentes.

2. Cellule solaire tandem à base de pérovskite (100) selon la revendication 1, dans laquelle, dans une direction perpendiculaire à une direction d'extension des lignes de grille métallique (107), deux limites latérales d'une projection des lignes de grille métallique (107) sur la cellule en silicium cristallin (202) sont situées à l'intérieur de deux limites latérales d'une projection des barres omnibus métalliques (201) sur la cellule en silicium cristallin (202).

3. Cellule solaire tandem à base de pérovskite (100) selon la revendication 1, dans laquelle chaque cellule à base de pérovskite comprend :
une pluralité de premières lignes de grille métallique (107) s'étendant sur la première électrode transparente (106) dans une première direction horizontale, et la pluralité de premières lignes de grille métallique (107) sont espacées suivant une seconde direction horizontale ; et
une pluralité de secondes lignes de grille métallique (108) s'étendant sur la première électrode transparente (106) dans la seconde direction horizontale, et la pluralité de secondes lignes de grille métallique (108) sont espacées suivant la première direction horizontale ; dans laquelle la pluralité de premières lignes de grille métallique (107) et la pluralité de secondes lignes de grille métallique (108) s'intersectent pour former un motif de grille.

4. Cellule solaire tandem à base de pérovskite (100) selon la revendication 3, dans laquelle la cellule en silicium cristallin (202) comprend :
une pluralité de barres omnibus métalliques (201) espacées sur le dessus et/ou le dessous de la cellule en silicium cristallin (202), et la pluralité de barres omnibus métalliques (201) s'étend dans la première direction horizontale et sont espacées suivant la seconde direction horizontale ; et
une pluralité de doigts (203) espacés sur le dessus et/ou le dessous de la cellule en silicium cristallin (202), la pluralité de doigts (203) s'étend dans la seconde direction horizontale et sont espacés suivant la première direction horizontale, et la pluralité de barres omnibus métalliques (201) et la pluralité de doigts (203) s'intersectent pour former un motif de grille sur le dessus et/ou le dessous de la cellule en silicium cristallin.

5. Cellule solaire tandem à base de pérovskite (100) selon la revendication 4, dans laquelle chaque première ligne de grille métallique (107) est disposée au-dessus d'une barre omnibus métallique correspondante (201), et chaque seconde ligne de grille métallique (108) est disposée au-dessus d'un doigt correspondant (203).

6. Cellule solaire tandem à base de pérovskite (100) selon la revendication 4, dans laquelle les premières lignes de grille métallique (107) s'intersectent perpendiculairement avec les secondes lignes de grille métallique (108), et au moins une seconde ligne de grille métallique (108) s'intersectant perpendiculairement avec la première ligne de grille métallique (107) de la cellule à base de pérovskite est prévue sur la même cellule à base de pérovskite.

7. Cellule solaire tandem à base de pérovskite (100) selon l'une quelconque des revendications 1 à 4, dans laquelle une largeur des lignes de grille métallique (107, 108) est comprise entre 0,5 mm et 5 mm.

8. Cellule solaire tandem à base de pérovskite (100) selon l'une quelconque des revendications 1 à 4, dans laquelle un matériau des lignes de grille métallique (107) comprend au moins l'un des éléments suivants : or, argent, cuivre et aluminium.

9. Cellule solaire tandem à base de pérovskite (100) selon la revendication 1, dans laquelle la première couche de transport de porteurs est une couche de transport d'électrons (ETL) ou une couche de transport de trous (HTL), et la seconde couche de transport de porteurs est également une couche de transport d'électrons (ETL) ou une couche de transport de trous (HTL).
